# EUROPEAN PATENT SPECIFICATION

(11) **EP 1 376 865 B1**
(45) Date of publication and mention of the grant of the patent: **23.11.2011**
(21) Application number: 03291499.6
(22) Date of filing: 19.06.2003
(51) Int. Cl.: H03H 9/64

(54) **Surface acoustic wave filter, branching filter, and communications apparatus**
Akustischer Oberflächenwellenfilter, Abzweigfilter und Kommunikationsvorrichtung
Filtre à ondes acoustiques de surface, filtre d'aiguillage et appareil de communication

(30) Priority: 19.06.2002 JP 2002178235
(43) Date of publication of application: 02.01.2004
(73) Proprietor: MURATA MANUFACTURING CO., LTD., Nagaokakyo-shi, Kyoto 617-8555 (JP)
(72) Inventor: Takata, Toshiaki, Intellectual Property Department, Nagaokakyo-shi, Kyoto-fu 617-8555 (JP)
(74) Representative: Thévenet, Jean-Bruno

(56) References cited:
- EP-A- 0 600 705
- EP-A- 0 758 819
- EP-A- 0 874 457
- US-A- 5 077 544
- PATENT ABSTRACTS OF JAPAN vol. 1999, no. 11, 30 September 1999 (1999-09-30) & JP 11 163664 A (KYOCERA CORP), 18 June 1999 (1999-06-18)
- HIKITA M ET AL: "Design methodology and synthesis techniques for ladder-type SAW resonator coupled filters" ULTRASONICS SYMPOSIUM, 1993. PROCEEDINGS., IEEE 1993 BALTIMORE, MD, USA 31 OCT.-3 NOV. 1993, NEW YORK, NY, USA,IEEE, 31 October 1993 (1993-10-31), pages 15-24, XP010114974 ISBN: 0-7803-1278-3
- INOUE T ET AL: "CONSTRUCTION METHOD FOR LADDER FILTERS EMPLOYING PIEZOELECTRIC CERAMIC RESONATORS" TRANSACTIONS OF THE INSTITUTE OF ELECTRONICS AND COMMUNICATION ENGINEERS OF JAPAN, SECTION E, INST. OF ELECTRONICS & COMMUNIC. ENGINEERS OF JAPAN. TOKYO, JP, vol. E69, no. 7, July 1986 (1986-07), pages 788-795, XP002056797

## Description

### BACKGROUND OF THE INVENTION

### 1. Field of the Invention

The present invention relates to surface acoustic wave filters used as band-pass filters. More specifically, the present invention relates to a surface acoustic wave filter including a plurality of one-terminal-pair surface acoustic wave resonators arranged in a ladder pattern, and to a branching filter and a communications apparatus.

### 2. Description of the Related Art

In recent years, surface acoustic wave (SAW) filters including one-terminal-pair SAW resonators, which are used in a high-frequency band (RF band, in particular, GHz band or more) of communications apparatuses such as mobile phones, have been developed. The SAW filter is compact and lightweight, is highly resistant to shock and vibration, and is highly reliable with reduced variations in products. Also, the circuit need not be adjusted, so that the filter can be easily mounted automatically. In addition, the filter for a high-frequency band can be easily manufactured.

Although not shown, the one-terminal-pair SAW resonator includes a piezoelectric substrate; an interdigital transducer (hereinafter referred to as IDT) including an interdigital electrode (hereinafter referred to as IDT electrode) having a pair of comb electrodes; and two reflectors sandwiching the IDT at the right and left thereof (in the propagation direction of a surface acoustic wave (hereinafter referred to as SAW)), the IDT and the reflectors being aligned in the propagation direction of a SAW on the piezoelectric substrate.

The IDT is formed by a metallic thin-film comprising aluminum or the like, and functions as a SAW transducer, which transforms an input electric signal (AC) to a SAW (elastic energy) so as to propagate the SAW on the piezoelectric substrate and which also transforms the propagated SAW to an electric signal so as to output the signal. The reflectors reflect the propagated SAW in the propagated direction.

In such an IDT, a signal transform characteristic and a pass band can be set by defining the length and width of each electrode finger of the IDT electrode, the pitch of adjacent electrode fingers, and the width of the overlapping portion of interdigitated electrode fingers. Also, in the reflector, a reflection characteristic can be set by adjusting the width of each electrode finger and the pitch thereof.

As an example of the above-described SAW filter, Japanese Unexamined Patent Application Publication No. 5-183380 discloses a ladder band-pass filter in which a one-terminal-pair SAW resonator of a series arm and a one-terminal-pair SAW resonator of a parallel arm are alternately arranged.

In this ladder filter, a first one-terminal-pair SAW resonator is connected in series and a second one-terminal-pair SAW resonator is connected in parallel. By making the antiresonance frequency of the parallel resonator substantially correspond to the resonance frequency of the series resonator, very favorable filter characteristics of low loss and a wide band can be obtained. Therefore, this type of filter has been widely used mainly in communications apparatuses.

Also, the above-described official gazette discloses that a wide band filter characteristic can be obtained by adding a series inductance to the series resonator or the parallel resonator.

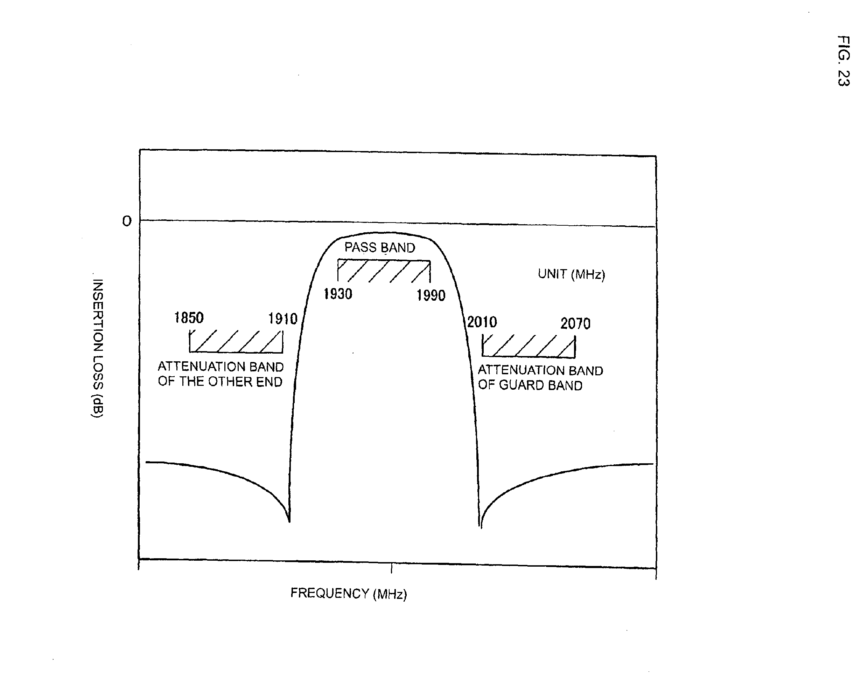

However, this type of filter is required to have a favorable reflection characteristic and a steep attenuation characteristic in the vicinity of the pass band, in addition to a characteristic for use in a wide band. Also, in a filter typified by an Rx RF filter of GSM 1900 shown in Fig. 23, if attenuation bands exist at the vicinities of both sides of the pass band, adjustment is required so as to obtain a steep attenuation characteristic in the vicinity and an adequate pass bandwidth.

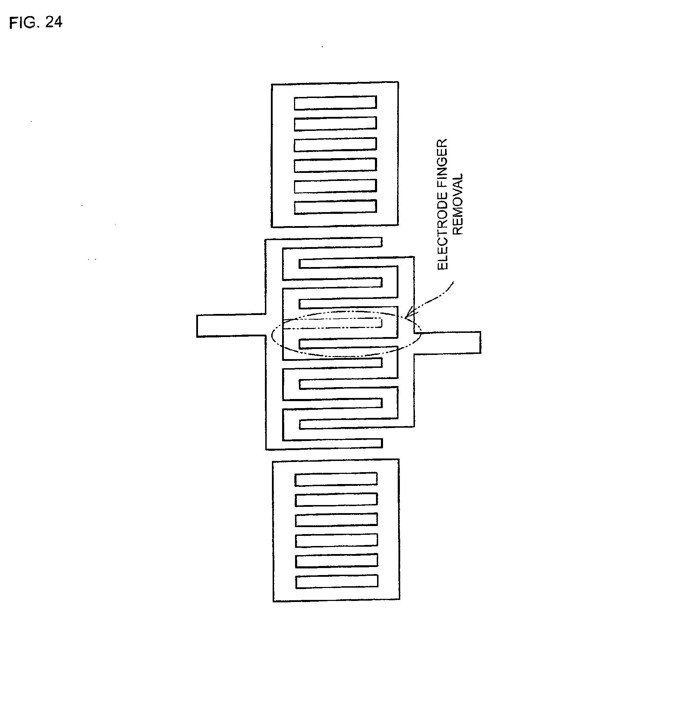

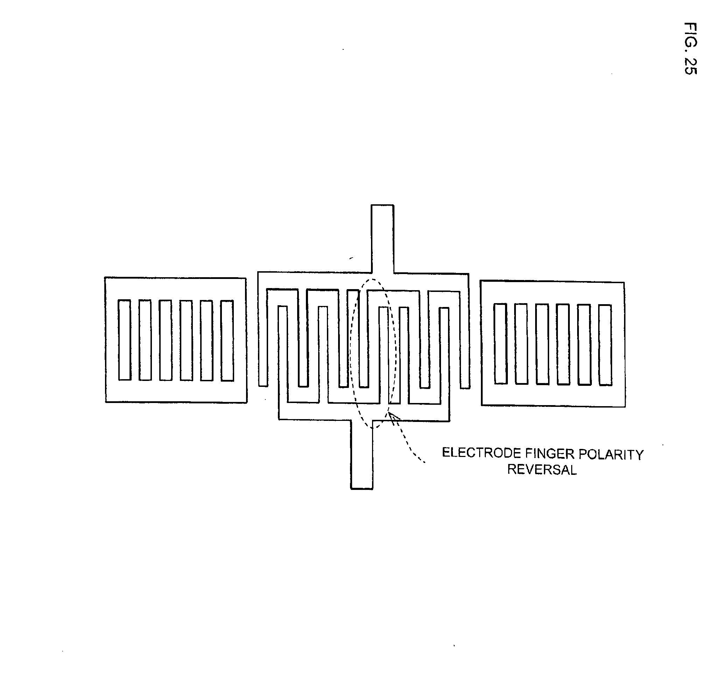

As a method for obtaining an adequate pass bandwidth so as to obtain a steep attenuation characteristic in the vicinity of the pass band, a method of applying a thinned-out electrode has been known. A thinned-out electrode is an IDT electrode in which some of the electrode fingers are removed (see Fig. 24) or the polarity of some of the electrode fingers is reversed (see Fig. 25) so that an electric field is not applied to a number of the electrode fingers. In other words, thinning-out of the electrode can be expressed as withdrawal weighting.

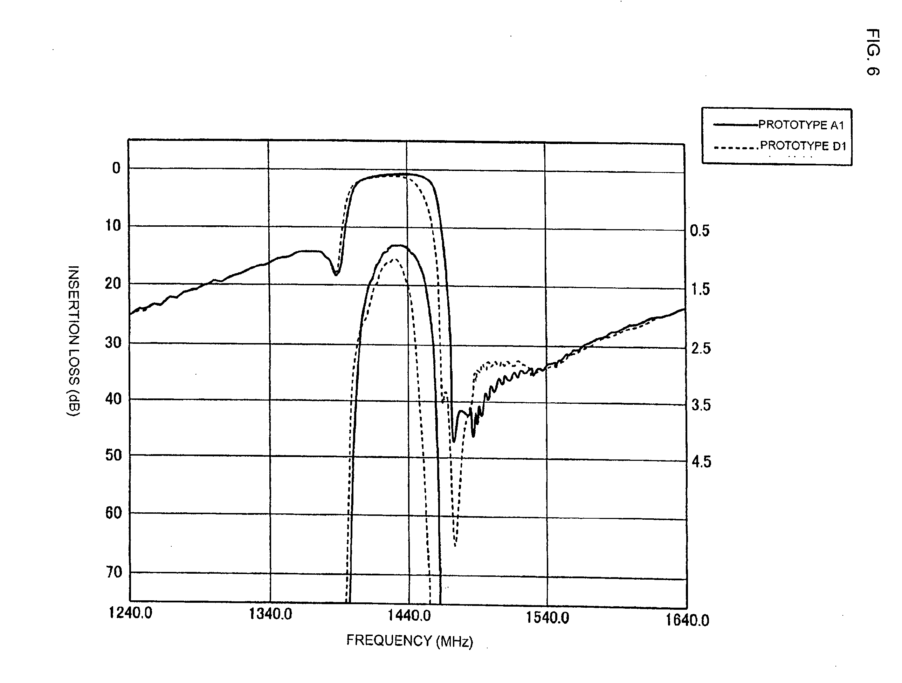

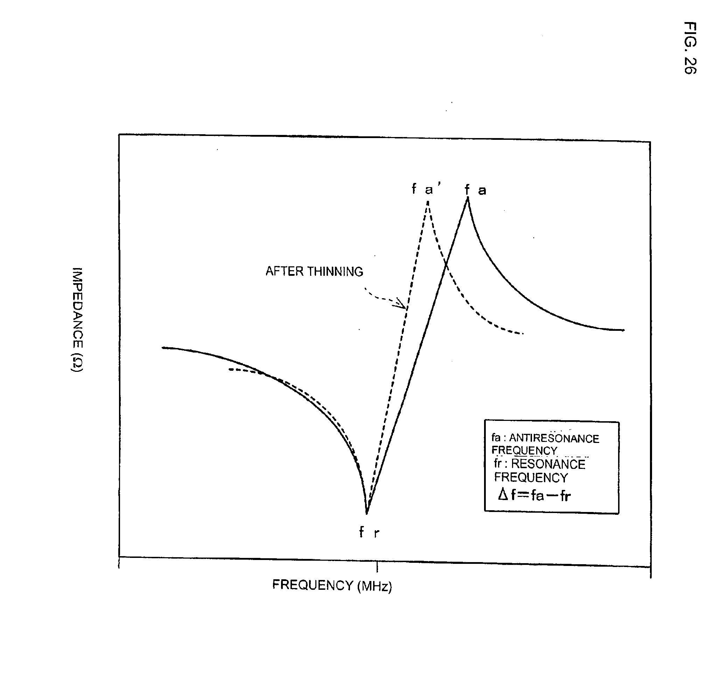

Japanese Unexamined Patent Application Publication No. 11-163664 (published on June 18, 1999) discloses a SAW filter including IDT electrodes which are thinned-out in a regular manner. In an embodiment thereof, a ladder filter is disclosed. As shown in Fig. 26, by thinning-out an IDT electrode, the antiresonance frequency is shifted toward the resonance frequency, so that the gap Δf between the resonance frequency and the antiresonance frequency can be reduced. By applying this method to a ladder filter, free adjustment can be performed, for example, the steepness in the vicinity of the pass band can be improved and the pass bandwidth can be reduced, as shown in Fig. 6 of the above-described official gazette.

Also, PCT Japanese Translation Patent Publication No. 2001-500697 (published on January 16, 2001) discloses a ladder filter having a similar advantage.

Further, Japanese Unexamined Patent Application Publication No. 9-153753 (published on June 10, 1997) discloses the following method. That is, in this method, weighting is performed so that the conductance of an IDT electrode is reduced to a small value in a desired frequency band. Further, by changing the electrode pitch, an adequate attenuation bandwidth can be ensured. By using this method, a filter characteristic in which attenuation outside the pass band is steep and the attenuation bandwidth is wide can be obtained. Incidentally, Japanese Unexamined Patent Application Publication No. 9-153753 does not disclose nor suggest thinning-out of the IDT electrode.

However, when a one-terminal-pair SAW resonator including a thinned-out IDT electrode is applied to a ladder filter, the attenuation characteristic of an attenuation band in the vicinity of the pass band leaps, and thus a frequency characteristic is disadvantageously deteriorated.

The reason for this disadvantage is as follows. Due to a variation in the characteristic shown in Fig. 6 of Japanese Unexamined Patent Application Publication No. 11-163664, the impedance characteristic in the vicinity of a high-frequency side becomes smaller than the antiresonance frequency in a series resonator, and the impedance characteristic in the vicinity of a low-frequency side becomes larger than the resonance frequency in a parallel resonator. Accordingly, the impedance characteristic in the frequency range of the attenuation band varies.

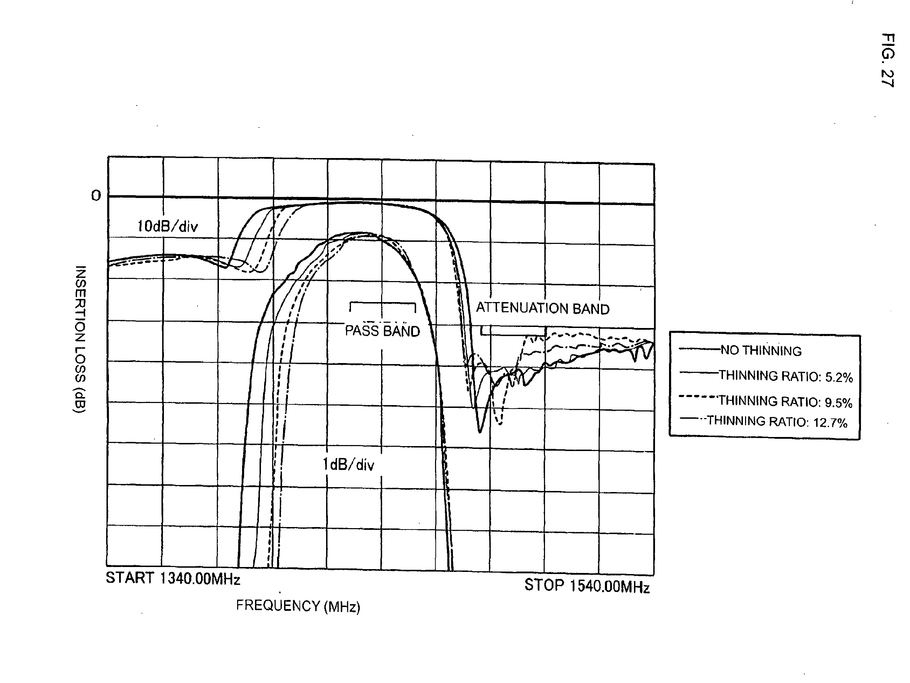

Fig. 27 shows examples of the electrical frequency characteristic of a Tx filter, in which all series resonators are thinned-out at the same thinning ratio, which is varied, and the center frequency is adjusted by changing the entire electrode pitch so as to adjust the frequencies of the pass band and the attenuation band. The thinning ratio is a value indicating the ratio of thinned-out (e.g. removed) electrode fingers with respect to the original number of pairs of electrode fingers of the IDT electrode.

Fig. 27 shows the above-described tendency: the frequency characteristic is deteriorated as the thinning ratio becomes higher. Therefore, even if a thinned-out electrode is applied so as to improve steepness, the attenuation characteristic of the entire attenuation band is deteriorated due to a leap of the attenuation characteristic.

In the method described in Japanese Unexamined Patent Application Publication No. 9-153753, by weighting an electrode and changing the electrode pitch, the above-mentioned leap of the attenuation characteristic can be suppressed and improved.

In Japanese Unexamined Patent Application Publication No. 9-153753, however, a thinned-out electrode is not disclosed and only an electrode using apodization is disclosed, which differs from the present application in its configuration. In apodization, the area of an electrode is disadvantageously larger than that of a thinned-out electrode, and thus a filter cannot be miniaturized compared to the case where a thinned-out electrode is applied.

For example, if the electrodes of all series resonators are thinned-out at the same thinning ratio, the steepness is improved but the leap in the attenuation band becomes significant, as shown in Fig. 27.

On the other hand, if the electrode pitch is optimized, the leap in the attenuation band can be alleviated, but the reflection characteristic is deteriorated. Therefore, with the configuration of the known art, it is difficult to optimize and improve both reflection and attenuation characteristics.

EP-A-0 874 457 describes a SAW filter including a plurality of SAW resonators arranged in a ladder configuration, notably a π-configuration. In order to improve impedance matching between the different π-type ladder sections of the filter, an extra series resonator is included in the filter, between the π-type ladder sections, and the pitch of the IDT electrode fingers in the extra series resonator is set smaller than that of the other series resonators.

EP-A-0 758 819 describes a SAW filter in which steeper flanks are generated at the ends of the passband by controlling the spacing between the outmost IDT electrode finger and the outermost part of the neighbouring reflector in one or more parallel resonators. By setting the spacing between the IDT and the reflector less than λ/2, a spurious component is generated at a frequency where is can help sharpen the steepness of the passband. EP-A-0 758 819 does not consider any effects that may be achievable by control of the electrode finger pitch within the resonators of the filter.

JP 11-163664 describes a SAW filter including a plurality of SAW resonators in which, in order to obtain a sharp cut-off at the sides of the passband, the IDT electrodes of the SAW resonators are thinned-out. There is no suggestion that there should be any differentiation in the thinning-out process. Moreover, JP 11-163664 specifically proposes to use thinning-out in order to improve steepness of the flanks of the passband characteristic instead of using alternative known techniques. JP 11-163664 explicitly aims to avoid adjusting the spacing between the IDT electrode and the reflector in a resonator/ the spacing between electrode fingers.

### SUMMARY OF THE INVENTION

An object of the present invention is to provide a surface acoustic wave filter in which reflection and attenuation characteristics can be improved by changing not only an electrode pitch but also a thinning ratio.

In order to achieve the above-described object, according to an aspect of the present invention, a surface acoustic wave filter includes:
a piezoelectric substrate; and
a plurality of one-terminal-pair surface acoustic wave resonators disposed on the piezoelectric substrate in a ladder pattern, each resonator including an IDT electrode having a pair of comb electrodes,
wherein the plurality of one-terminal-pair surface acoustic wave resonators include series resonators and all of the series resonators are thinned-out,
the plurality of one-terminal-pair surface acoustic wave resonators are arranged in a T-shape, in which a series resonator is connected to each of the input/output sides, and
the IDT electrode of at least one of the series resonators other than the series resonators connected to the input/output sides has a greater thinning ratio and a smaller electrode pitch than those of the IDT electrodes of the other series resonators

Preferably, the above-described surface acoustic wave filter serves as a transmission filter which requires attenuation outside a pass band in the vicinity of a high-frequency side of the pass band.

In this configuration, all the series resonators are thinned-out, and the IDT electrode of at least one of the series resonators other than the series resonators connected to each of the input/output sides has a greater thinning ratio and a smaller electrode pitch than those of the IDT electrodes of the other series resonators. Accordingly, the attenuation characteristic, particularly the attenuation characteristic outside the pass band at the high-frequency side, can be improved by thinning-out. Also, a leap in the attenuation band can be suppressed by changing the electrode pitch, and at the same time, the reflection characteristic in the pass band can be improved. Further, the attenuation characteristic outside the pass band (particularly at the high-frequency side) in the vicinity of the pass band and the reflection characteristic in the pass band can be improved in a well-balanced manner. As a result, a surface acoustic wave filter having an improved reflection and attenuation characteristics and lower loss compared to the known art can be provided.

According to another aspect of the present invention, a surface acoustic wave filter includes:
a piezoelectric substrate; and
a plurality of one-terminal-pair surface acoustic wave resonators disposed on the piezoelectric substrate in a ladder pattern, each resonator including an IDT electrode having a pair of comb electrodes,
wherein the plurality of one-terminal-pair surface acoustic wave resonators include parallel resonators and all of the parallel resonators are thinned-out,
the plurality of one-terminal-pair surface acoustic wave resonators are arranged in a π-shape, in which a parallel resonator is connected to each of the input/output sides, and
the IDT electrode of at least one of the parallel resonators other than the parallel resonators connected to the input/output sides has a greater thinning ratio and a smaller electrode pitch than those of the IDT electrodes of the other parallel resonators.

Preferably, the above-described surface acoustic wave filter serves as a reception filter which requires attenuation outside a pass band in the vicinity of a low-frequency side of the pass band.

In the above-described configuration, the IDT of at least one of the parallel resonators other than the parallel resonators connected to the input/output sides has a greater thinning ratio and a smaller electrode pitch than those of the other parallel resonators. Accordingly, a steep attenuation characteristic outside the pass band in the vicinity of the pass band (particularly, at the low-frequency side), the attenuation characteristic in an attenuation band, and the reflection characteristic can be improved in a well-balanced manner. As a result, all the disadvantages of the known art can be overcome, and a compact surface acoustic wave filter having improved reflection and decompression characteristics and low loss can be provided.

A branching filter of the present invention includes the above-described surface acoustic wave filter.

A communications apparatus of the present invention includes the above-described surface acoustic wave filter.

The above and further objects, features and advantages of the present invention will become clear from the following description of preferred embodiments thereof, given by way of example, illustrated with reference to the accompanying drawings, in which:

### BRIEF DESCRIPTION OF THE DRAWINGS

Fig. 1 is a circuit diagram of a surface acoustic wave (SAW) filter according to a first embodiment of the present invention;
Fig. 2 is a schematic view showing the configuration of the SAW filter;
Fig. 3 is a cross-sectional view showing a state where the SAW filter is accommodated in a package;
Fig. 4 is a graph showing the frequency characteristic of insertion loss of prototypes A1, B1, and C1 of the SAW filter;
Fig. 5 is a graph showing the frequency characteristic of VSWR of S11 of the prototypes A1, B1, and C1 of the SAW filter;
Fig. 6 is a graph showing the frequency characteristic of insertion loss of prototypes A1 and D1 of the SAW filter;
Fig. 7 is a graph showing the frequency characteristic of VSWR of S11 of the prototypes A1 and D1 of the SAW filter;
Fig. 8 is a graph showing the frequency characteristic of insertion loss of prototypes B1, C1, and E1 of the SAW filter;
Fig. 9 is a graph showing the frequency characteristic of VSWR of S11 of the prototypes B1, C1, and E1 of the SAW filter;
Fig. 10 is a graph showing the frequency characteristic of impedance in resonators in a comparative example, where mismatch of the resonators is caused;
Fig. 11 is a graph showing the frequency characteristic of impedance in resonators in the first embodiment, where mismatch of the resonators is reduced;
Fig. 12 is a circuit diagram of a SAW filter according to a second embodiment of the present invention;
Fig. 13 is a schematic view showing the configuration of the SAW filter;
Fig. 14 is a graph showing the frequency characteristic of insertion loss of prototypes A2, B2, and C2 of the SAW filter;
Fig. 15 is a graph showing the frequency characteristic of VSWR of S11 of the prototypes A2, B2, and C2 of the SAW filter;
Fig. 16 is a graph showing the frequency characteristic of insertion loss of prototypes A2 and D2 of the SAW filter;
Fig. 17 is a graph showing the frequency characteristic of VSWR of S11 of the prototypes A2 and D2 of the SAW filter;
Fig. 18 is a graph showing the frequency characteristic of insertion loss of prototypes B2, C2, and E2 of the SAW filter;
Fig. 19 is a graph showing the frequency characteristic of VSWR of S11 of the prototypes B2, C2, and E2 of the SAW filter;
Fig. 20 is a graph showing the frequency characteristic of impedance in resonators in a comparative example, where mismatch of the resonators is caused;
Fig. 21 is a circuit block diagram of a branching filter including the SAW filter of the present invention;
Fig. 22 is a circuit block diagram of a communications apparatus including the SAW filter of the present invention;
Fig. 23 is a graph showing the frequency characteristic of insertion loss in a known SAW filter;
Fig 24 is a schematic view of an IDT of the known SAW filter, an example of a thinned-out electrode being shown;
Fig 25 is a schematic view of the IDT of the known SAW filter, another example of a thinned-out electrode being shown;
Fig. 26 is a graph showing a variation in the frequency characteristic of impedance in the known SAW filter, the variation being caused by thinning-out; and
Fig. 27 is a graph showing the frequency characteristic of insertion loss in the known SAW filter, in which the thinning ratio is changed.

### DESCRIPTION OF THE PREFERRED EMBODIMENTS

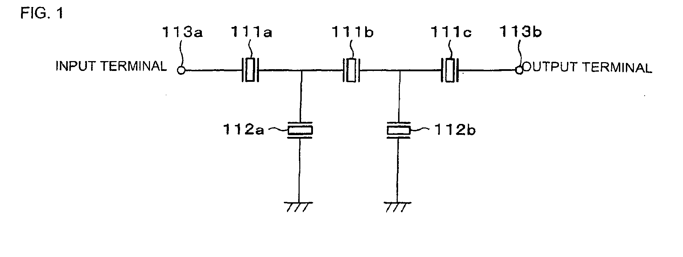

Hereinafter, embodiments of a surface acoustic wave (SAW) filter according to the present invention will be described with reference to Figs. 1 to 20.

### First Embodiment

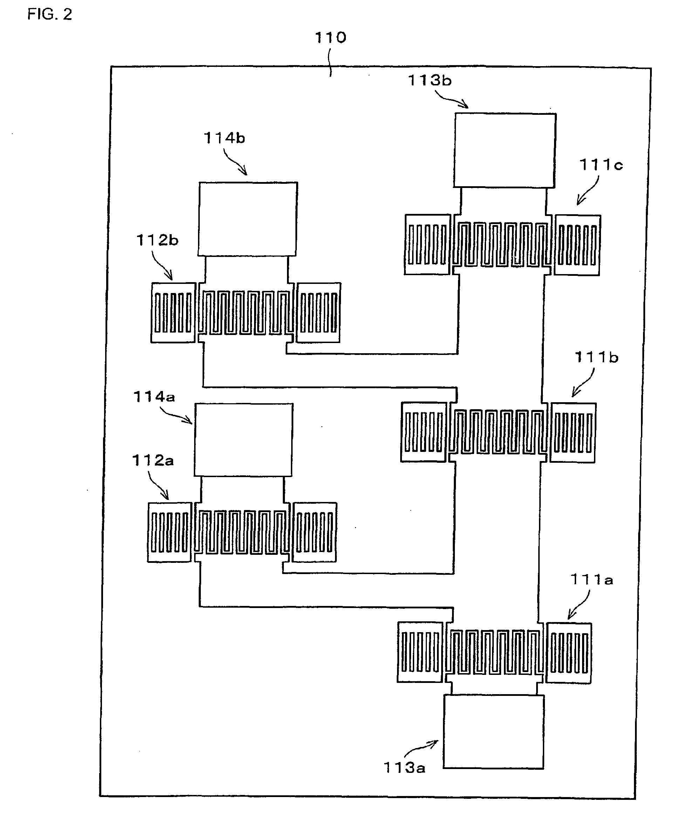

As a SAW filter of the first embodiment, a ladder-type Tx filter in which the center frequency of the pass band is 1441 MHz is used. As shown in a circuit diagram in Fig. 1 and a schematic view in Fig. 2, the SAW filter includes series resonators 111a to 111c and parallel resonators 112a and 112b, which are arranged in a ladder pattern on a piezoelectric substrate 110.

Preferably, the series resonators 111a to 111c and the parallel resonators 112a and 112b are arranged such that the surface acoustic waves generated therefrom propagate substantially in parallel to each other, so that the filter can be miniaturized.

The series resonators 111a to 111c are connected in series between an input terminal 113a and an output terminal 113b, and are aligned in a direction substantially orthogonal to the propagation direction of the surface acoustic waves generated from the series resonators 111a to 111c.

On the other hand, the parallel resonators 112a and 112b are connected between the series resonators 111a to 111c and the earth (ground potential). Also, the parallel resonators 112a and 112b are aligned in a direction substantially orthogonal to the propagation direction of the surface acoustic waves generated from the parallel resonators 112a and 112b. Accordingly, the extension lines of the surface acoustic waves generated from the parallel resonators 112a and 112b do not overlap those of the surface acoustic waves generated from the series resonators 111a to 111c.

The above-described SAW filter has a T-shaped configuration, in which the series resonator 111a is connected to the input terminal 113a and the series resonator 111 c is connected to the output terminal 113b.

In this specification, the above-described configuration is referred to as a T-shaped configuration, in which a series resonator should be connected to each of input and output sides, but the combination of the other series and parallel resonators may be arranged in any way. In the first embodiment, the three series resonators 111a to 111c and the two parallel resonators 112a and 112b are formed on the piezoelectric substrate 110 comprising 36° rotated Y-cut X-propagation LiTaO₃, by photolithography and lift-off.

The series resonators 111 a and 111 c have the same configuration, that is, the width of the overlapping portion of the electrode fingers is 30 µm, the number of effective pairs of electrode fingers of the IDT electrode except thinned-out electrode finger(s) is 200, and the number of electrode fingers of reflectors is 100. On the other hand, the series resonator 111b has a different configuration, that is, the width of the overlapping portion of the electrode fingers is 15 µm, the number of effective pairs of electrode fingers of the IDT electrode is 200, and the number of electrode fingers of reflectors is 100.

The parallel resonators 112a and 112b have the same configuration, that is, the width of the overlapping portion of the electrode fingers is 30 µm, the number of pairs of electrode fingers of the IDT electrode is 200, and the number of electrode fingers of reflectors is 100. The IDT electrode of each of the three series resonators 111 a to 111 c is thinned-out.

A method of reversing a polarity shown in Fig. 25 is used in order to thin out the electrode. Preferably, thinning-out is not performed at regular intervals, but the thinning ratio becomes gradually higher from the left to the right of the IDT electrode (becomes higher with distance from the parallel resonators 112a and 112b).

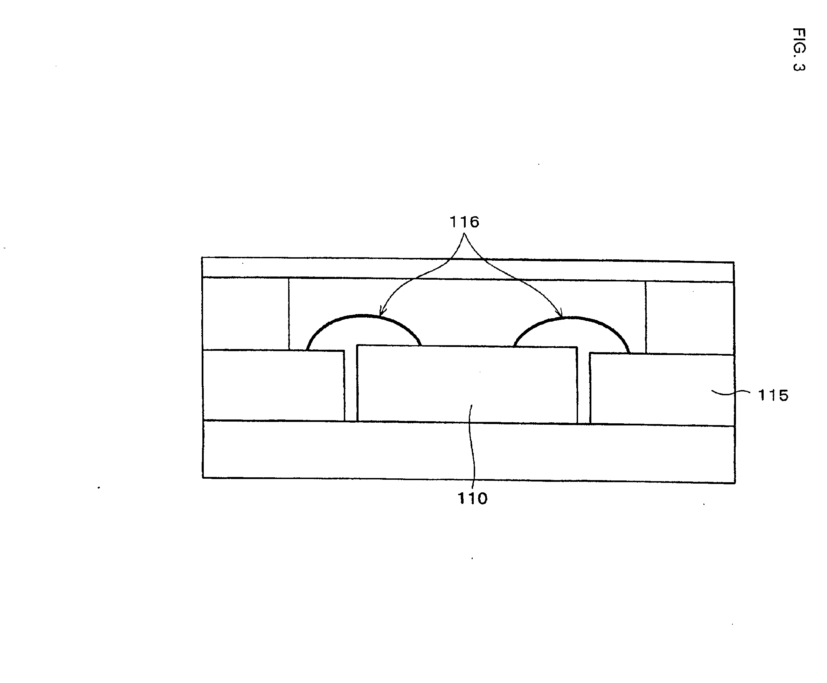

Each of the input terminal 113a and the output terminal 113b is formed in a substantially rectangular pad shape. Likewise, each of earth terminals 114a and 114b connected to the parallel resonators 112a and 112b is formed in a substantially rectangular pad shape. As shown in Fig. 3, the electrodes are electrically connected to a package 115 by bonding wires 116.

Tables 1 and 2 show the relationship between the thinning ratio and the electrode pitch of the series resonators 111 a to 111 c. In a prototype A1 (within the scope of the present invention), both of the thinning ratio and the electrode pitch of the series resonator 111b differ from those of the series resonators 111a and 111c. In a prototype B1 (first comparative example), the thinning ratio is the same in all the series resonators 111 a to 111 c, whereas the electrode pitch of the series resonator 111b differs from that of the series resonators 111 a and 111c.
In a prototype C1 (second comparative example), the conditions are the same as those in the prototype B1, except that the electrode pitch of the series resonator 111 b is changed. In a prototype D1 (third comparative example), the electrode pitch is the same in all the series resonators 111 a to 111 c, whereas the thinning ratio of the series resonator 111 b differs from that of the series resonators 111 a and 111 c. In a prototype E1 (fourth comparative example), both of the thinning ratio and the electrode pitch are the same in all the series resonators 111 a to 111 c.

**Table 1**

| | Prototype A1 | Prototype B1 | Prototype C1 |
|---|---|---|---|
| Thinning ratio | 111a and 111c: 5.20% | 111a and 111c: 5.20% | 111a and 111c: 5.20% |
| | 111b: 12.70% | 111b: 5.20% | 111b: 5.20% |
| Electrode pitch | 111a and 111c: 1.3657 µm | 111a and 111c: 1.3657 µm | 111 a and 111c: 1.3657 µm |
| | 111 b: 1.3484 µm | 111 b: 1.3484 µm | 111 b: 1.3575 µm |

**Table 2**

| | Prototype D1 | Prototype E1 |
|---|---|---|
| Thinning ratio | 111a and 111c: 5.20% | 111a and 111c: 5.20% |
| | 111b: 12.70% | 111b: 5.20% |
| Electrode pitch | 111a and 111c: 1.3657 µm | 111a and 111c: 1.3657 µm |
| | 111b: 1.3657 µm | 111b: 1.3657 µm |

In the prototype A1, the thinning ratio and the electrode pitch are optimized so that a favorable attenuation characteristic and reflection characteristic (voltage standing wave ratio (VSWR)) can be obtained. On the other hand, the prototype B1 is the first comparative example in which the thinning ratio is the same in all the series resonators and only the electrode pitch is optimized so as to obtain a favorable reflection characteristic. Also, the prototype C1 is the second comparative example in which the thinning ratio is the same in all the series resonators and only the electrode pitch is optimized so as to obtain a favorable attenuation characteristic. The prototype D1 is the third comparative example in which the electrode pitch is the same in all the series resonators but the thinning ratio of the series resonator 111b differs from that of the series resonators 111a and 111c. The prototype E1 is the fourth comparative example in which both of the thinning ratio and the electrode pitch are the same in all the series resonators.

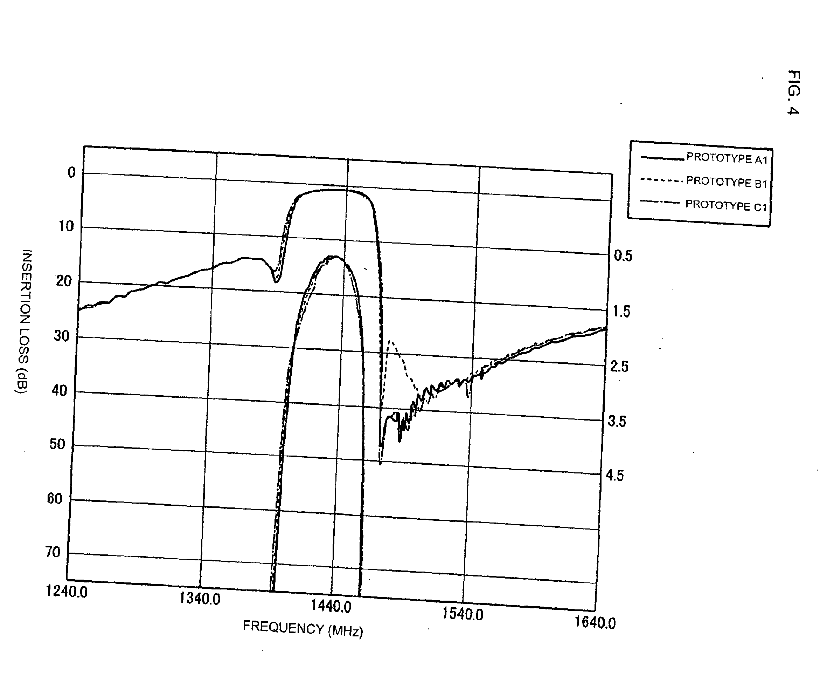

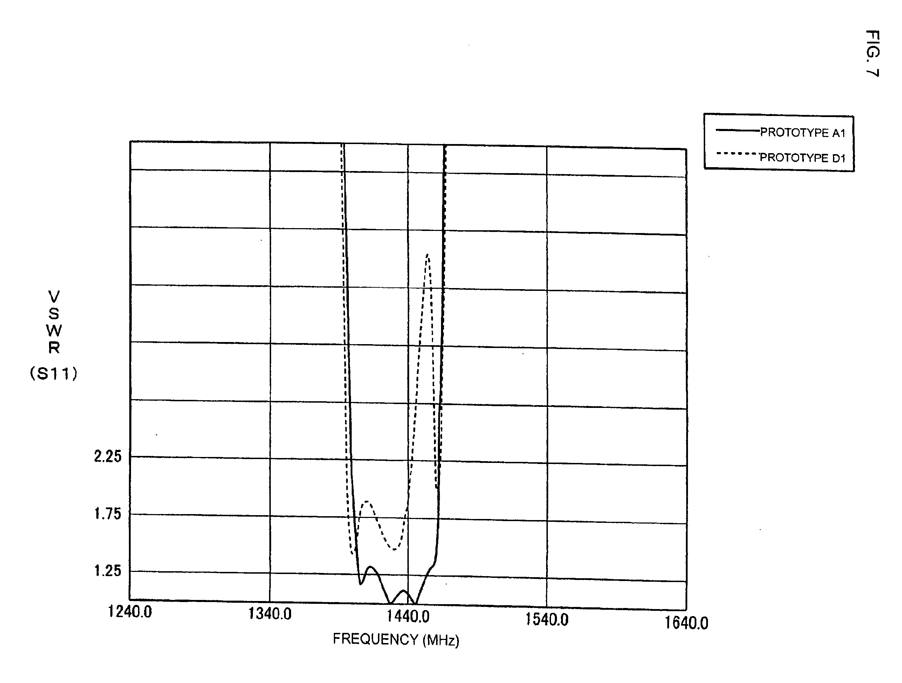

The electrical characteristic of each of the prototypes A1 to E1 is shown in Figs. 4 to 9. Figs. 6 and 7 show comparative data of the prototype D1, in which the electrode pitch is the same in all the series resonators but the thinning ratio of the series resonator 111 b differs from that of the series resonators 111 a and 111 c. As is clear from Figs. 6 and 7, the following can be understood by comparing the prototype A1 with the prototype D1. That is, in the prototype D1, the pass band is narrower, the leap in the attenuation band is more significant, and the reflection characteristic (VSWR) is worse than in the prototype A1. Accordingly, the effectiveness of changing the electrode pitch can be clearly seen.

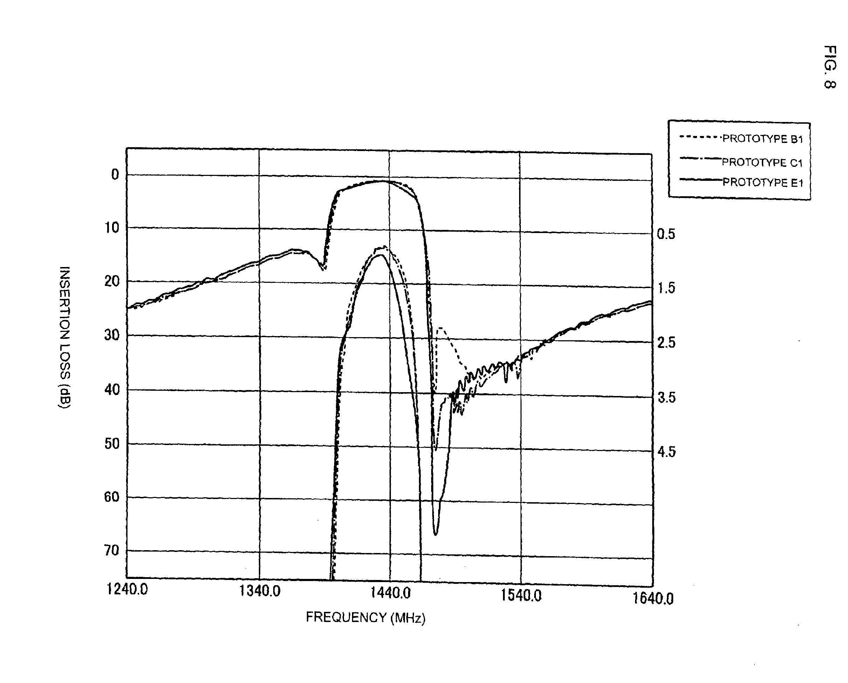

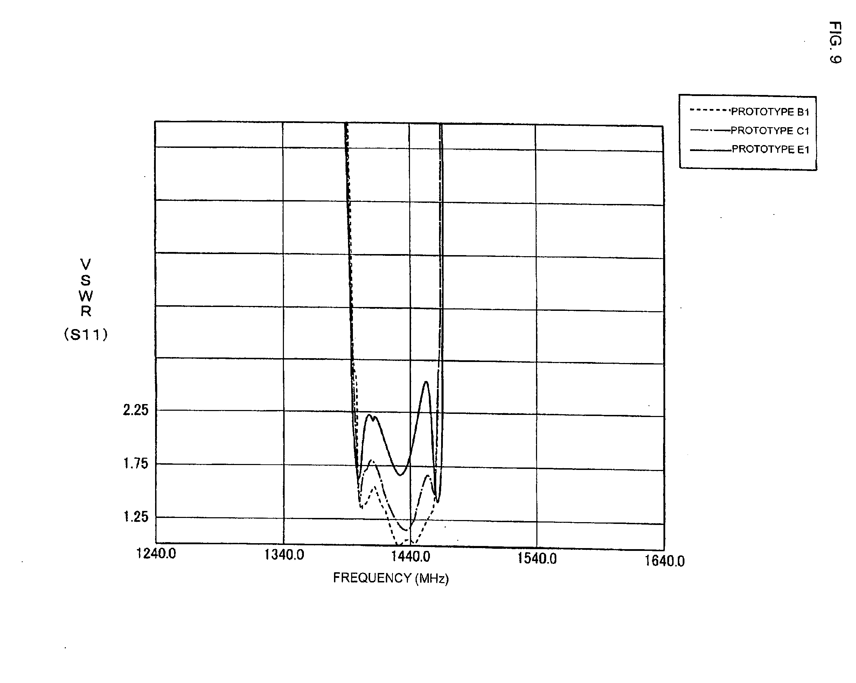

Also, as can be seen in Figs. 8 and 9, the prototypes B1 and C1, in which the electrode pitch is different, have a better reflection characteristic in the pass band compared with that of the prototype E1 based on the known art. In this way, by setting the electrode pitch different, a reflection characteristic can be improved while applying thinning-out and increasing steepness.

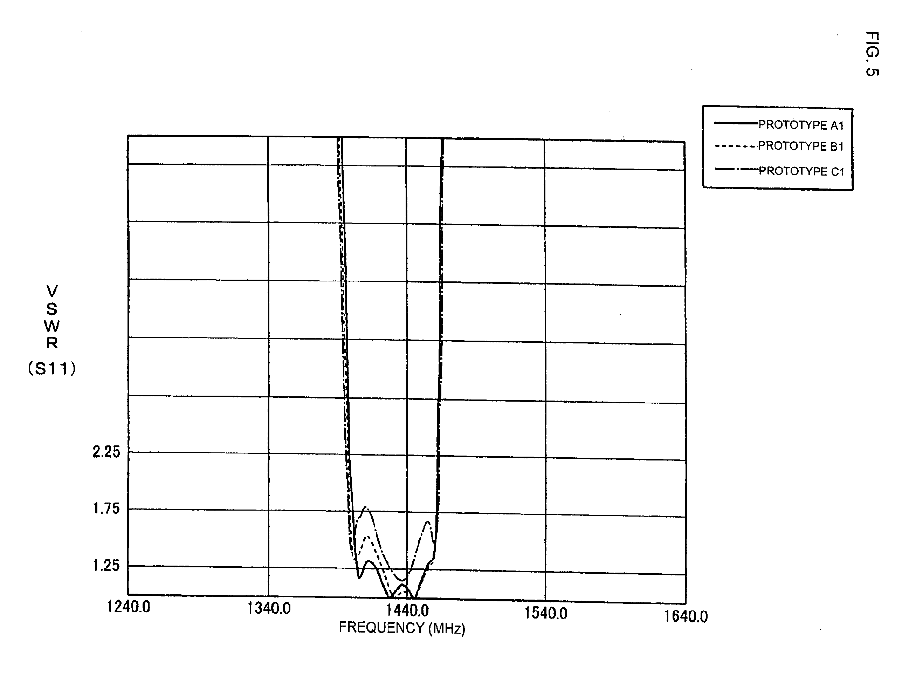

Figs. 4 and 5 show the compared results for the prototypes A1, B1, and C1. In the prototype A1, the attenuation characteristic in the vicinity of the high-frequency side of the pass band and the reflection characteristic in the pass band are favorable. On the other hand, in the prototypes B1 and C1, one of the attenuation and reflection characteristics is worse than that of the prototype A1. The reason for this is as follows.

In the series resonators, a difference in resonance frequency of the resonators is a factor of changing the reflection characteristic. Also, a difference in antiresonance frequency of the resonators is a factor of changing the attenuation characteristic. In the prototype A1, the difference in resonance frequency corresponds to the difference in the electrode pitch. Also, the difference in antiresonance frequency corresponds to the difference in the thinning ratio. By optimizing the differences in the electrode pitch and the thinning ratio, favorable attenuation and reflection characteristics can be obtained.

On the other hand, in the prototypes B1 and C1, the difference in only one of resonance frequency and antiresonance frequency can be optimized. Therefore, one of attenuation and reflection characteristics is deteriorated.

In general, the optimal value of the difference in the electrode pitch of the resonators for ensuring an adequate attenuation bandwidth is different from the optimal value of the difference in the electrode pitch of the resonators for obtaining the best reflection characteristic. Therefore, higher priority must be given to one of the optimal values. In order to optimize both of the attenuation bandwidth and the reflection characteristic, both of the electrode pitch and the thinning ratio must be changed.

The reason for applying the T-shaped configuration and changing the electrode pitch and thinning ratio of the central series resonator 111b in this embodiment is as follows. In a general method of designing a ladder filter, a combination of a series resonator and a parallel resonator is regarded as one unit, and the number of stages is increased based on this unit so as to cascade resonators, as described in Japanese Unexamined Patent Application Publication No. 5-183380.

Accordingly, in the T-shaped configuration in which a series resonator is connected to each of the input and output sides, an equivalent capacitance, which depends on the number of pairs of electrode fingers and the width of the overlapping portion, of the central series resonator is smaller than that of the series resonators connected to the input and output sides. Further, the effect of attenuation characteristic depending on the capacitance is increased. Therefore, when the thinning ratio and the electrode pitch of the central series resonator 111b are different from those of the series resonators in the input and output sides, the effect of the present invention becomes most significant.

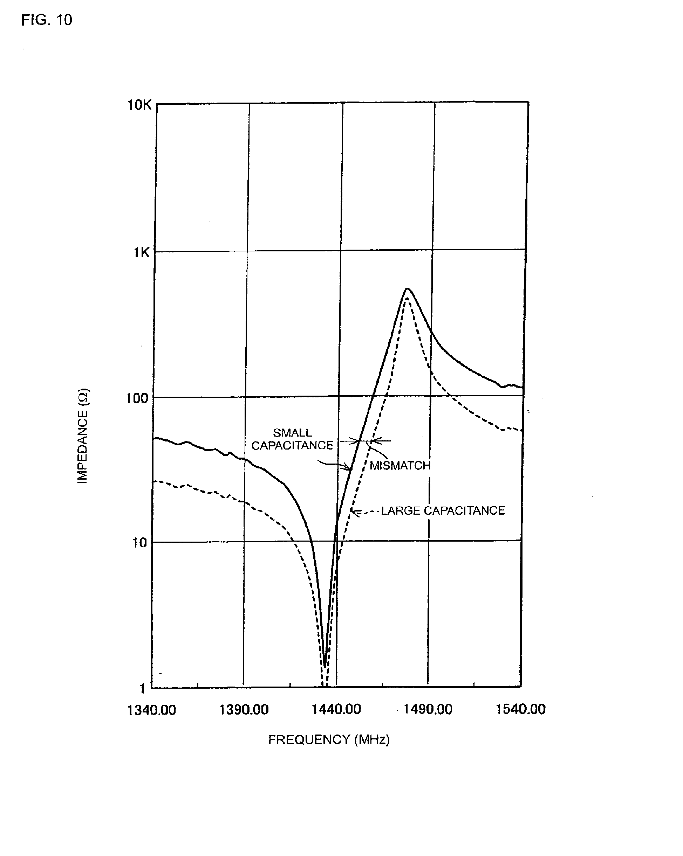

In the prototype A1, the electrode pitch is smaller and the thinning ratio is higher in the series resonator 111 b compared with the series resonators 111a and 111c. The reason for this is as follows. As described above, the equivalent capacitance of the central series resonator 111b is smaller than that of the series resonators 111a and 111c, which are connected to the input and output sides. As shown in Fig. 10, when the resonators have a different capacitance, a mismatch is caused in the impedance characteristic between the resonance frequency and the antiresonance frequency.

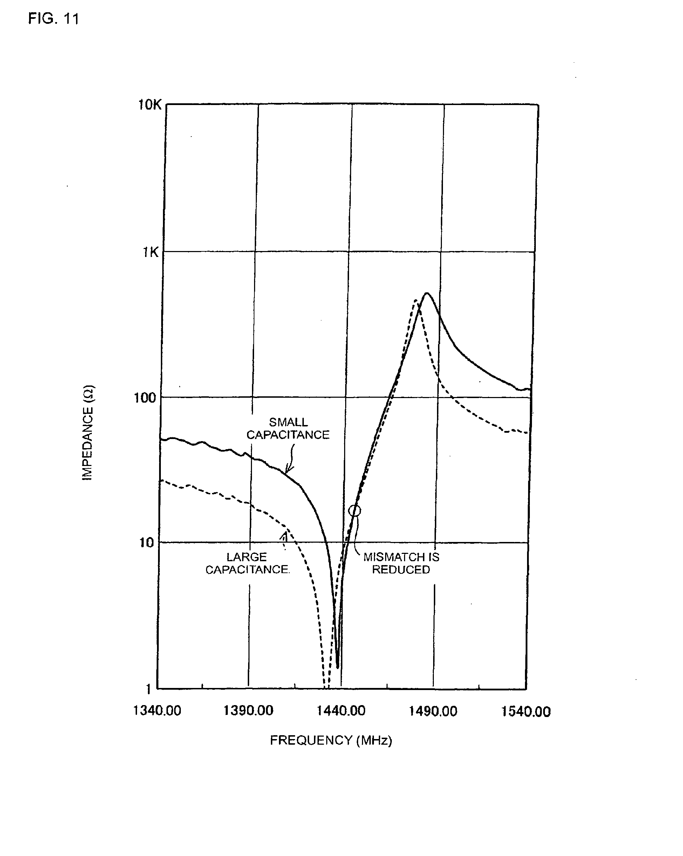

In this case, as shown in Fig. 11, by reducing the electrode pitch and increasing the frequency so as to eliminate the mismatch, the reflection characteristic can be improved in that range. At this time, however, the frequency is increased and the difference in antiresonance frequency becomes large, and thus the attenuation characteristic is deteriorated. In order to overcome this problem, the thinning ratio is increased so as to adequately reduce the difference in antiresonance frequency. Accordingly, the attenuation characteristic can be improved.

Therefore, the effect of the present invention can be enhanced by reducing the electrode pitch and increasing the thinning ratio in the central series resonator 111b. In particular, in the configuration according to the first embodiment, a significant effect could be obtained by setting the following conditions: the electrode pitch of the central series resonator 111 b is 0.975 times smaller than that of the series resonators 111a and 111c (more preferably, the minimum is 0.980 times and the maximum is 0.995 times), and the thinning ratio of the central series resonator 111b is 2.7 times higher than that of the series resonators 111a and 111c (more preferably, the minimum is 2.0 times and the maximum is 2.5 times).

As the capacitance of the central series resonator is reduced, the attenuation characteristic is improved, whereas the mismatch increases and the reflection characteristic is deteriorated. At this time, by applying the configuration of the present invention, the reflection characteristic can be significantly improved and leap in the attenuation band can be prevented. Thus, a favorable filter characteristic can be obtained.

The thinning-out configuration of this embodiment is not limited to the above-described configuration. Alternatively, the configuration shown in Fig. 24 can be adopted. That is, any configuration can be adopted as long as an electric field is not applied to some of the electrode fingers. Also, any range of the IDT electrode may be thinned-out regularly or irregularly. However, the above described manner of thinning-out is preferable.

In this embodiment, the piezoelectric substrate comprises 36° rotated Y-cut X-propagation LiTaO₃. However, another material may also be used for the substrate. For example, a 38°-46° rotated Y-cut X-propagation LiTaO₃ substrate or a 64°-72° rotated LiNbO₃ substrate may be used.

Also, the method of forming an electrode is not limited. For example, etching may be used instead of lift-off. Also, as a mounting method, a flip chip bonding may be used instead of wire bonding.

In the above-described ladder SAW filter, by thinning-out every series resonator and by setting the condition in which the electrode pitch of at least one of the series resonators is different from that of the other series resonators, the reflection characteristic in the pass band can be improved while increasing steepness. Further, by changing the thinning ratio, the attenuation characteristic in the vicinity of a high-frequency side of the pass band and the reflection characteristic in the pass band can be improved in a well-balanced manner. Accordingly, a compact SAW filter in which a reflection characteristic is improved, loss is reduced, and decompression characteristic is desirable compared with the known art, can be provided.

Further, by applying the T-shaped configuration in which a series resonator is connected to each of the input and output sides and by setting the condition in which the thinning ratio and the electrode pitch of the central series resonator is different from those of the other series resonators, the effect of the present invention can be enhanced.

Specifically, the electrode pitch of the central series resonator is smaller than that of the other series resonators, and the thinning ratio of the central series resonator is higher than that of the other series resonators. With this arrangement, the effect of the present invention can be further enhanced.

### Second embodiment

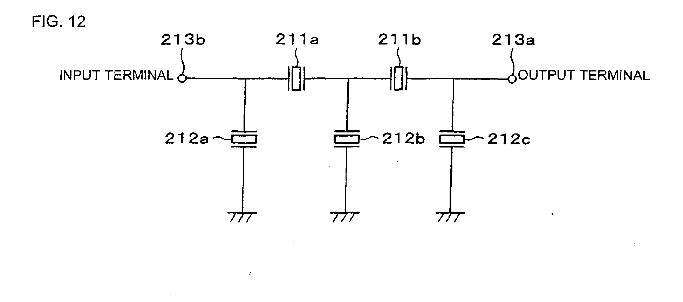

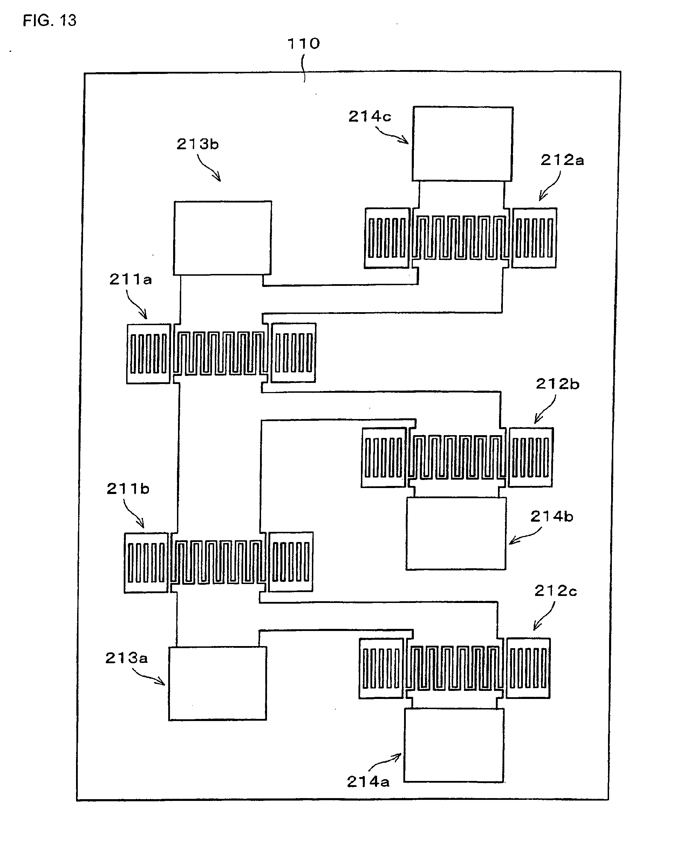

As a SAW filter of the second embodiment, a ladder-type Rx filter in which the center frequency is 1489 MHz is used. Fig. 12 is a circuit diagram of the second embodiment, and Fig. 13 is a schematic view showing IDT electrodes on the piezoelectric substrate 110. The SAW filter of this embodiment includes parallel resonators 212a to 212c and series resonators 211a and 211b, which are arranged on the piezoelectric substrate 110 in a manner pursuant to the first embodiment.

The SAW filter of this embodiment has a Π-shaped configuration, in which the parallel resonator 212a is connected to the input side and the parallel resonator 212c is connected to the output side. Herein, the above-described configuration is referred to as a Π-shaped configuration, in which the parallel resonators 212a and 212c should be connected to an input terminal 213b and an output terminal 213a respectively, but the combination of the other series and parallel resonators may be arranged in any way.

The parallel resonators 212a and 212c have the same configuration, that is, the width of the overlapping portion of the electrode fingers is 58 µm, the number of effective pairs of electrode fingers of the IDT electrode is 75, and the number of electrode fingers of the reflectors is 60. On the other hand, the parallel resonator 212b has a different configuration, that is, the width of the overlapping portion of the electrode fingers is 85 µm, the number of effective pairs of electrode fingers of the IDT electrode is 75, and the number of electrode fingers of the reflectors is 60. The series resonators 211a and 211b have the same configuration, that is, the width of the overlapping portion of the electrode fingers is 36 µm, the number of pairs of electrode fingers of the IDT electrode is 50, and the number of electrode fingers of the reflectors is 60.

The IDT electrode of each of the three parallel resonators 212a to 212c is thinned-out. As in the first embodiment, the method of reversing a polarity shown in Fig. 25 is used in order to thin-out the electrode. Preferably, thinning is not performed at regular intervals, but the thinning ratio becomes gradually higher from the left to the right of the IDT electrode (becomes higher with distance from the series resonators 211 a and 211 b).

Each of the input terminal 213b and the output terminal 213a is formed in a pad shape. Also, each of the earth terminals 214a to 214c is formed in a pad shape. The thinning-out method, the method of forming the piezoelectric substrate 110 and the electrodes, and the method of electrically connecting the electrodes with the package are the same as in the first embodiment.
Tables 3 and 4 show the relationship between the thinning ratio and the electrode pitch of the parallel resonators 212a to 212c. In a prototype A2 (within the scope of the present invention), both of the thinning ratio and the electrode pitch of the parallel resonator 212b differ from those of the parallel resonators 212a and 212c. In a prototype B2 (fifth comparative example), the thinning ratio is the same in all the parallel resonators 212a to 212c, whereas the electrode pitch of the parallel resonator 212b differs from that of the parallel resonators 212a and 212c. In a prototype C2 (sixth comparative example), the conditions are the same as those in the prototype B2, except that the electrode pitch of the parallel resonator 212b is changed. In a prototype D2 (seventh comparative example), the electrode pitch is the same in all the parallel resonators 212a to 212c, whereas the thinning ratio of the parallel resonator 212b differs from that of the parallel resonators 212a and 212c. In a prototype E2 (eighth comparative example), both of the thinning ratio and the electrode pitch are the same in all the parallel resonators 212a to 212c.

**Table 3**

| | Prototype A2 | Prototype B2 | Prototype C2 |
|---|---|---|---|
| Thinning ratio | 212a and 212c: 6.25% | 212a and 212c: 6.25% | 212a and 212c: 6.25% |
| | 212b: 9.60% | 212b: 6.25% | 212b: 6.25% |
| Electrode pitch | 212a and 212c: 1.3647 µm | 212a and 212c: 1.3647 µm | 212a and 212c: 1.3647 µm |
| | 212b: 1.3573 µm | 212b: 1.3573 µm | 212b: 1.3610 µm |

**Table 4**

| | Prototype D2 | Prototype E2 |
|---|---|---|
| Thinning ratio | 212a and 212c: 6.25% | 212a and 212c: 6.25% |
| | 212b: 9.60% | 212b: 6.25% |
| Electrode pitch | 212a and 212c: 1.3647 µm | 212a and 212c: 1.3647 µm |
| | 212b: 1.3647 µm | 212b: 1.3647 µm |

In prototype A2, the thinning ratio and the electrode pitch are optimized so that a favorable attenuation characteristic and reflection characteristic can be obtained. On the other hand, the prototype B2 is the fifth comparative example in which the thinning ratio is the same in all the parallel resonators and only the electrode pitch is optimized so as to obtain a favorable reflection characteristic. Also, the prototype C2 is the sixth comparative example in which the thinning ratio is the same in all the parallel resonators and only the electrode pitch is optimized so as to obtain a favorable attenuation characteristic. The prototype D2 is the seventh comparative example in which the electrode pitch is the same in all the parallel resonators but the thinning ratio of the parallel resonator 212b differs from that of the parallel resonators 212a and 212c. The prototype E2 is the eighth comparative example based on the known art in which both of the thinning ratio and the electrode pitch are the same in all the parallel resonators.

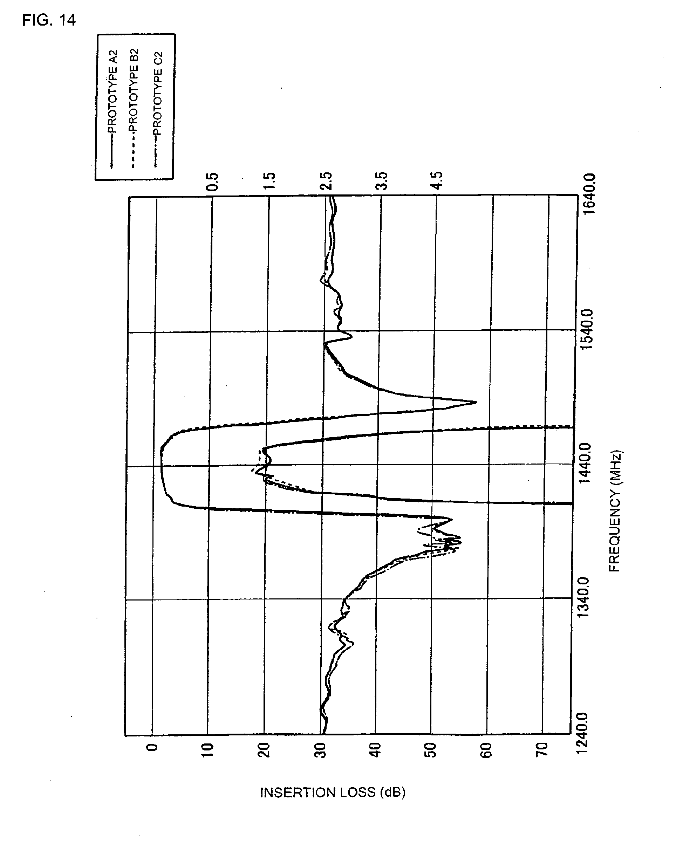

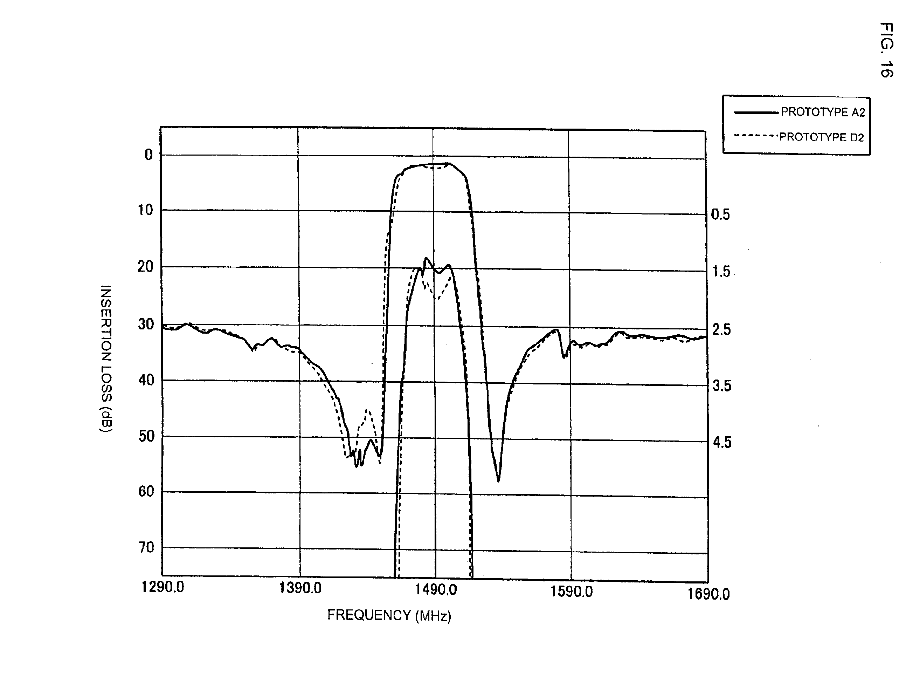

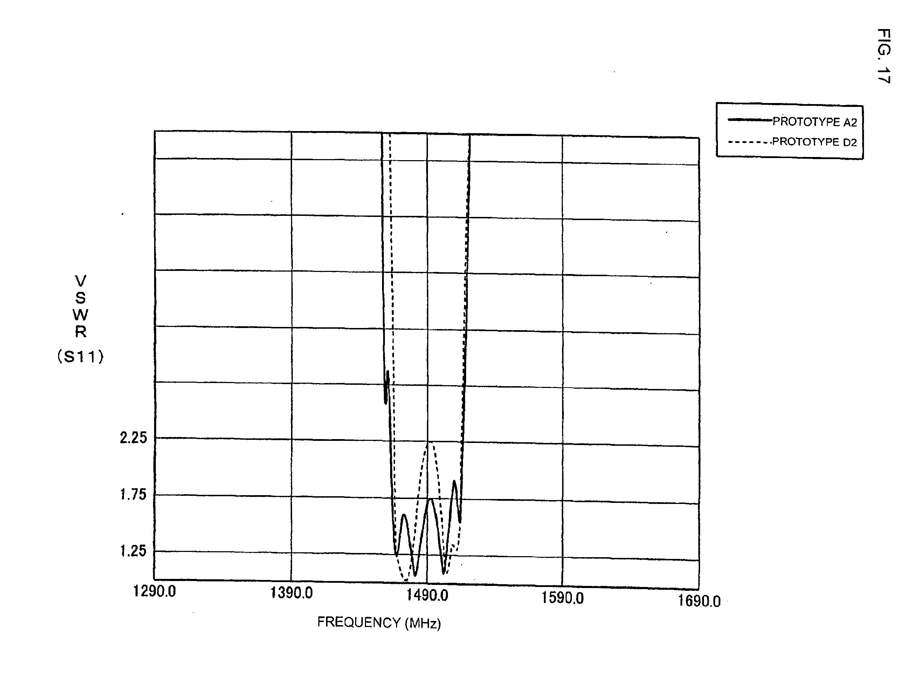

The electrical characteristic of each of the prototypes A2 to E2 is shown in Figs. 14 to 19. Figs. 16 and 17 show comparative data of the prototype D2, in which the electrode pitch is the same in all the parallel resonators but the thinning ratio of the parallel resonator 212b differs from that of the parallel resonators 212a and 212c. As is clear from Figs. 16 and 17, the following can be understood by comparing the prototype A2 with the prototype D2. That is, in the prototype D2, the reflection characteristic (VSWR) is worse than in the prototype A2. Accordingly, the effectiveness of changing the electrode pitch can be clearly seen.

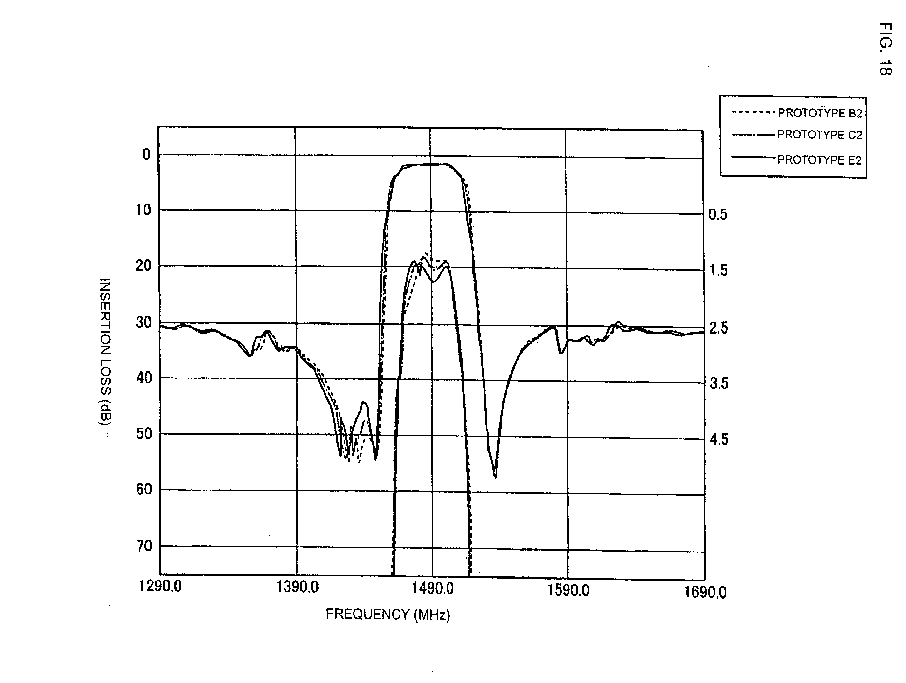

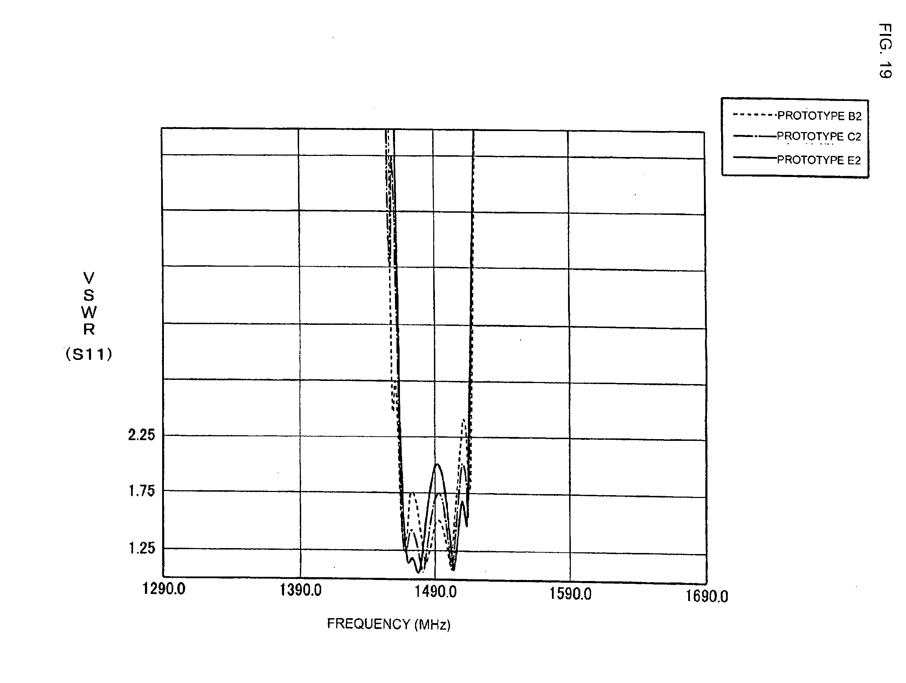

As can be seen in Figs. 18 and 19, the prototypes B2 and C2, in which the electrode pitch is different, have a better attenuation characteristic in the vicinity of a low-frequency side of the pass band, compared with that of the prototype E2 according to the fourth comparative example.

In this way, by setting the electrode pitch different, an attenuation characteristic can be improved by performing thinning and increasing steepness.

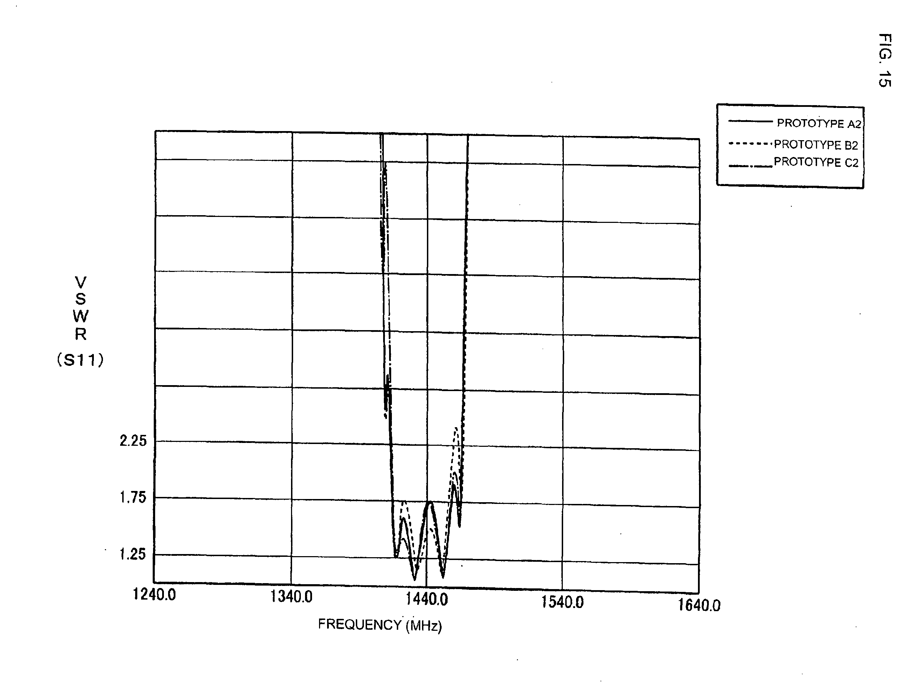

Figs. 14 and 15 show the compared results for the prototypes A2, B2, and C2. As is clear from Figs. 14 and 15, in the prototype A2, the attenuation characteristic in the vicinity of the low-frequency side of the pass band and the reflection characteristic in the pass band are favorable. On the other hand, in the prototypes B2 and C2, one of the attenuation and reflection characteristics is worse than that of the prototype A2. The reason for this is as follows, which is similar to the first embodiment.

In the parallel resonators, a difference in antiresonance frequency of the resonators is a factor of changing the reflection characteristic. Also, a difference in resonance frequency of the resonators is a factor of changing the attenuation characteristic. In the prototype A2, the difference in resonance frequency corresponds to the difference in the electrode pitch. Also, the difference in antiresonance frequency corresponds to the difference in the thinning ratio. By optimizing the differences in the electrode pitch and the thinning ratio, favorable attenuation and reflection characteristics can be obtained.

In the second embodiment, the π-shaped configuration is adopted and the central parallel resonator 212b has conditions different from those of the other parallel resonators. This is because the equivalent capacitance of the central parallel resonator 212b is increased. The reason is fundamentally the same as in the first embodiment, although the capacitance of the central resonator is large in the second embodiment.

In the prototype A2, the electrode pitch is smaller and the thinning ratio is higher in the parallel resonator 212b compared with the parallel resonators 212a and 212c. The reason for this is as follows. As described above, the equivalent capacitance of the central parallel resonator 212b is larger than that of the parallel resonators 212a and 212c, which are connected to the input terminal 213b and the output terminal 213a, respectively. Thus, the central parallel resonator 212b is susceptible to the inductance parasitizing on a wire or package. The reason for this is as follows.

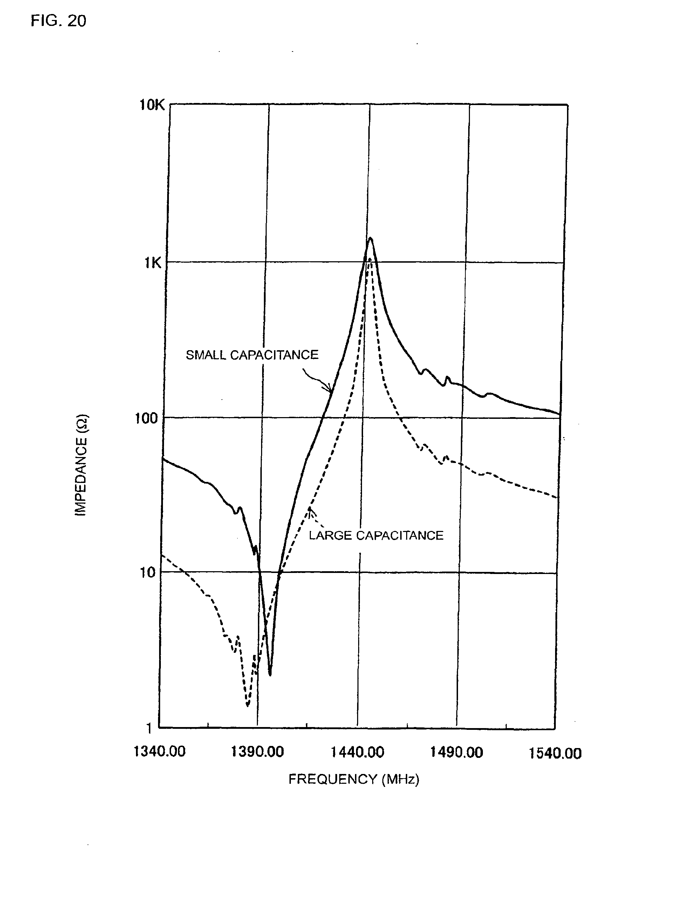

As shown in Fig. 20, when inductances having the same value are connected in series, the resonance frequency of a resonator having a larger capacitance is shifted to the low-frequency side. Accordingly, the difference in the resonance frequency of the parallel resonators at the input/output sides and the central parallel resonator is increased, and thus the attenuation characteristic in the vicinity of the low-frequency side of the pass band is deteriorated. In order to adequately reduce the difference in the resonance frequency, the electrode pitch of the central parallel resonator is reduced so as to increase the frequency. Accordingly, the attenuation characteristic can be improved.

At this time, however, by increasing the frequency, a mismatch of the impedance characteristic is increased and the reflection characteristic is deteriorated. In order to overcome this problem, the thinning ratio is increased and the antiresonance frequency is shifted to the high-frequency side, so that the mismatch is reduced and the reflection characteristic can be improved.

The effect of the present invention can be enhanced by reducing the electrode pitch and increasing the thinning ratio in the central parallel resonator 212b other than the parallel resonators 212a and 212c connected to the input terminal 213b and the output terminal 213a, respectively. In particular, in the second embodiment, a significant effect could be obtained by setting the following conditions: the electrode pitch of the central parallel resonator 212b can be made up to 0.991 times smaller than that of the parallel resonators 212a and 212c (more preferably, the minimum is 0.993 times and the maximum is 0.998 times), and the thinning ratio of the central parallel resonator 212b can be made up to 1.9 times higher than that of the parallel resonators 212a and 212c (more preferably, the minimum is 1.3 times and the maximum is 1.7 times).

As described above, in the ladder SAW filter, by thinning-out every parallel resonator and by setting the condition in which the electrode pitch of at least one of the parallel resonators is different from that of the other parallel resonators, the attenuation characteristic in the vicinity of the low-frequency side of the pass band can be improved while increasing the steepness.

Further, by changing the thinning ratio, the attenuation characteristic in the vicinity of the low-frequency side of the pass band and the reflection characteristic in the pass band can be improved in a well-balanced manner. Accordingly, a compact SAW filter in which a reflection characteristic is improved, loss is reduced, and a decompression characteristic is desirable compared with the known art, can be provided.

Further, by applying the π-shaped configuration in which a parallel resonator is connected to each of the input and output sides and by setting the condition in which the thinning ratio and the electrode pitch of the central parallel resonator is different from those of the other parallel resonators, the effect of the present invention can be enhanced.

Specifically, the electrode pitch of the central parallel resonator is smaller than that of the other parallel resonators, and the thinning ratio of the central parallel resonator is higher than that of the other parallel resonators. With this arrangement, the effect of the present invention can be further enhanced.

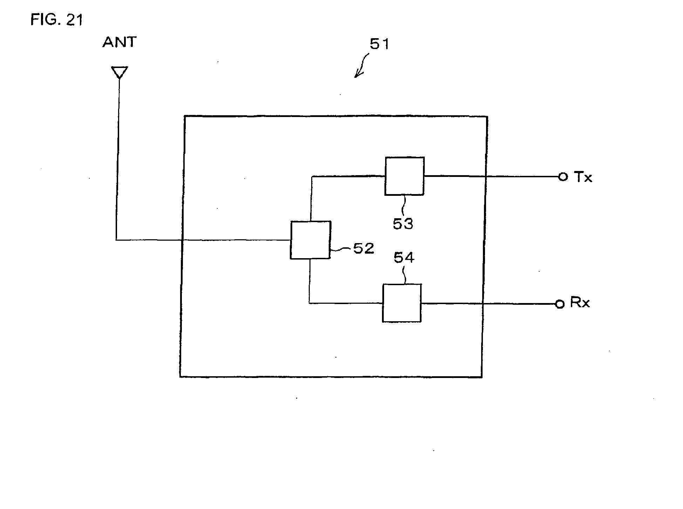

Fig. 21 shows a duplexer according to the present invention. The duplexer includes a matching circuit 52 connected to an antenna (ANT), a transmission filter 53 connected between the matching circuit 52 and a transmission terminal (Tx), and a reception filter 54 connected between the matching circuit 52 and a reception terminal (Rx). The transmission filter 53 and the reception filter 54 are set so that the pass band thereof is different from each other.

Preferably, the transmission filter 53 includes the prototype A1 described in the first embodiment, and the reception filter 54 includes the prototype A2 described in the second embodiment. By using the SAW filter of the present invention for at least one of the transmission filter 53 and the reception filter 54, a duplexer having suppressed shouldering and a favorable filter characteristic can be realized. Suppressed shouldering means that the frequency interval required to attenuate the frequency at the upper or lower end of the pass band to a predetermined attenuation frequency is small.

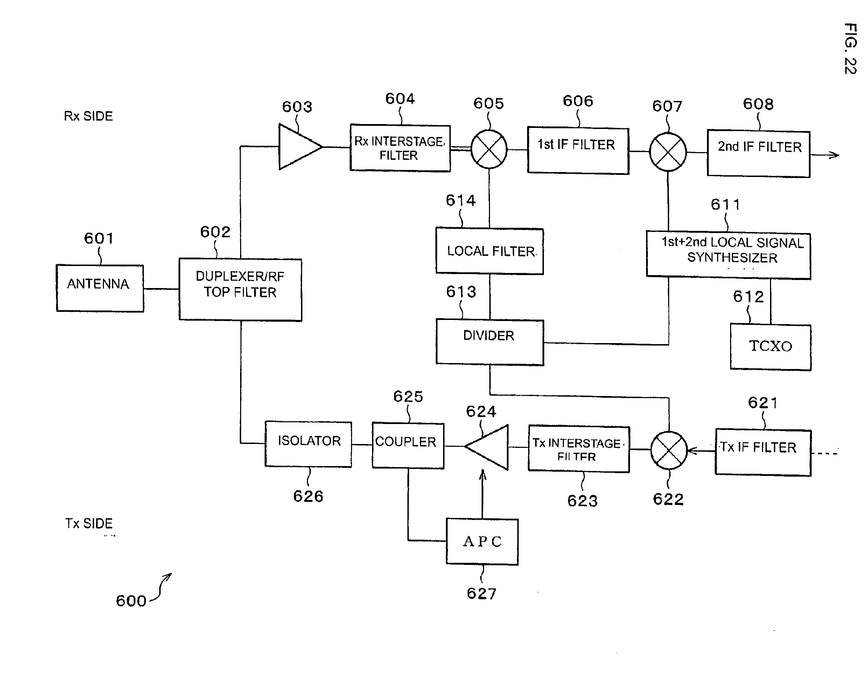

Next, a communications apparatus including the SAW filter of the above-described embodiments will be described with reference to Fig. 22. The receiver side (Rx side) of a communications apparatus 600 includes an antenna 601, a duplexer/RF top filter 602, an amplifier 603, an Rx interstage filter 604, a mixer 605, a 1st IF filter 606, a mixer 607, a 2nd IF filter 608, a 1st+2nd signal local synthesizer 611, a temperature compensated crystal oscillator (TCXO) 612, a divider 613, and a local filter 614.

Preferably, transmission is performed by balanced signals from the Rx interstage filter 604 to the mixer 605 in order to ensure a balance, as indicated by two lines of Fig. 22.

The transmission side (Tx side) of the communications apparatus 600 includes the antenna 601 and the duplexer/RF top filter 602, which are shared with the receiver side, a Tx IF filter 621, a mixer 622, a Tx interstage filter 623, an amplifier 624, a coupler 625, an isolator 626, and an automatic power control 627.

The SAW filter of the above-described embodiments can be preferably used for any or all of the Rx interstage filter 604, the 1st IF filter 606, the Tx IF filter 621, and the Tx interstage filter 623.

In the SAW filter according to the present invention, the reflection characteristic in the pass band can be improved while maintaining a steep attenuation characteristic outside the pass band. Also, the attenuation characteristic outside the pass band in the vicinity of the pass band (high-frequency side and low-frequency side) and the reflection characteristic in the pass band can be improved in a well balanced manner.

As a result, a SAW filter in which reflection and attenuation characteristics are improved and loss is lower than in the known art can be provided. Accordingly, in the communications apparatus of the present invention including the above-described SAW filter, a transmission characteristic can be improved.

## Claims

1. A surface acoustic wave filter comprising:
a piezoelectric substrate (110); and
a plurality of one-terminal-pair surface acoustic wave resonators (111,112) disposed on the piezoelectric substrate in a ladder pattern, each resonator including an IDT electrode having a pair of comb electrodes,
wherein the plurality of one-terminal-pair surface acoustic wave resonators include series resonators (111 a-c) and all of the series resonators (111 a-c) are thinned-out,
the plurality of one-terminal-pair surface acoustic wave resonators (111,112) are arranged in a T-shape, in which a series resonator (111a,c) is connected to each of the input/output sides (1113a,b), and
the IDT electrode of at least one (111 b) of the series resonators other than the series resonators connected to the input/output sides has a greater thinning ratio and a smaller electrode pitch than those of the IDT electrodes of the other series resonators (111a,c).

2. A surface acoustic wave filter comprising:
a piezoelectric substrate (110); and
a plurality of one-terminal-pair surface acoustic wave resonators (211,212) disposed on the piezoelectric substrate in a ladder pattern, each resonator including an IDT electrode having a pair of comb electrodes,
wherein the plurality of one-terminal-pair surface acoustic wave resonators include parallel resonators (212a-c) and all of the parallel resonators (212a-c) are thinned-out,
the plurality of one-terminal-pair surface acoustic wave resonators (211,212) are arranged in a π-shape, in which a parallel resonator (211 a,c) is connected to each of the input/output sides (213a,b), and
the IDT electrode of at least one (212b) of the parallel resonators other than the parallel resonators connected to the input/output sides has a greater thinning ratio and a smaller electrode pitch than those of the IDT electrodes of the other parallel resonators (212a,c).

3. The surface acoustic wave filter according to Claim 1, wherein the filter serves as a transmission filter which requires attenuation outside a pass band in the vicinity of a high-frequency side of the pass band.

4. The surface acoustic wave filter according to Claim 2, wherein the filter serves as a reception filter which requires attenuation outside a pass band in the vicinity of a low-frequency side of the pass band.

5. A branching filter comprising the surface acoustic wave filter according to any previous Claim.

6. A communications apparatus comprising the surface acoustic wave filter according to any previous Claim.

## Patentansprüche

1. Ein Oberflächenwellenfilter, das folgende Merkmale aufweist:
ein piezoelektrisches Substrat (110); und
eine Mehrzahl von Ein-Anschluss-Paar-Oberflächenwellenresonatoren (111, 112), die auf dem piezoelektrischen Substrat in einer Leiterstruktur angeordnet sind, wobei jeder Resonator eine IDT-Elektrode mit einem Paar von Kammelektroden umfasst,
wobei die Mehrzahl von Ein-Anschluss-Paar-Oberflächenwellenresonatoren Reihenresonatoren (111a-c) umfasst und alle der Reihenresonatoren (111a-c) ausgedünnt sind,
die Mehrzahl von Ein-Anschluss-Paar-Oberflächenwellenresonatoren (111, 112) in einer T-Form angeordnet ist, bei der ein Reihenresonator (111a,c) mit jeder der Eingangs/Ausgangsseiten (113a,b) verbunden ist, und
die IDT-Elektrode von zumindest einem (111b) der Reihenresonatoren außer den Reihenresonatoren, die mit den Eingangs/Ausgangsseiten verbunden sind, ein größeres Ausdünnungsverhältnis und einen geringeren Elektrodenabstand aufweist als diejenigen der IDT-Elektroden der anderen Reihenresonatoren (111a,c).

2. Ein Oberflächenwellenfilter, das folgende Merkmale aufweist:
ein piezoelektrisches Substrat (110); und
eine Mehrzahl von Ein-Anschluss-Paar-Oberflächenwellenresonatoren (211, 212), die auf dem piezoelektrischen Substrat in einer Leiterstruktur angeordnet sind, wobei jeder Resonator eine IDT-Elektrode mit einem Paar von Kammelektroden umfasst,
wobei die Mehrzahl von Ein-Anschluss-Paar-Oberflächenwellenresonatoren Parallelresonatoren (212a-c) umfasst und alle der Parallelresonatoren (212a-c) ausgedünnt sind,
die Mehrzahl von Ein-Anschluss-Paar-Oberflächenwellenresonatoren (211, 212) in einer π-Form angeordnet ist, bei der ein Parallelresonator (211a,c) mit jeder der Eingangs/Ausgangsseiten (213a,b) verbunden ist, und
die IDT-Elektrode von zumindest einem (212b) der Parallelresonatoren außer den Parallelresonatoren, die mit den Eingangs/Ausgangsseiten verbunden sind, ein größeres Ausdünnungsverhältnis und einen geringeren Elektrodenabstand aufweist als diejenigen der IDT-Elektroden der anderen Parallelresonatoren (212a,c).

3. Das Oberflächenwellenfilter gemäß Anspruch 1, bei dem das Filter als ein Übertragungsfilter dient, das Dämpfung außerhalb eines Durchlassbandes in der Nähe einer Hochfrequenzseite des Durchlassbandes erfordert.

4. Das Oberflächenwellenfilter gemäß Anspruch 2, bei dem das Filter als ein Empfangsfilter dient, das Dämpfung außerhalb eines Durchlassbandes in der Nähe einer Niederfrequenzseite des Durchlassbandes erfordert.

5. Ein Verzweigungsfilter, das das Oberflächenwellenfilter gemäß einem der vorhergehenden Ansprüche aufweist.

6. Eine Kommunikationsvorrichtung, die das Oberflächenwellenfilter gemäß einem der vorhergehenden Ansprüche aufweist.

## Revendications

1. Filtre à ondes acoustiques de surface comprenant :
un substrat piézoélectrique (110) ; et
une pluralité de résonateurs à ondes acoustiques de surface à une seule paire de bornes (111, 112) disposés sur le substrat piézoélectrique selon un motif en échelle, chaque résonateur comprenant une électrode IDT ayant une paire d'électrodes en peigne,
dans lequel
la pluralité de résonateurs à ondes acoustiques de surface à une seule paire de bornes comprend des résonateurs série (111a-c), et tous les résonateurs série (111a-c) sont éclaircis,
la pluralité de résonateurs à ondes acoustiques de surface à une seule paire de bornes (111, 112) sont agencés en une forme de T, avec un résonateur série (111a, c) connecté à chacun des côtés entrée/sortie (113a, b), et
l'électrode IDT d'au moins l'un (111b) des résonateurs série autre que les résonateurs série connectés aux côtés entrée/sortie ont un plus grand rapport d'éclaircissement et un plus petit pas d'électrode que ceux des électrodes IDT des autres résonateurs série (111a, c).

2. Filtre à ondes acoustiques de surface comprenant :
un substrat piézoélectrique (110) ; et
une pluralité de résonateurs à ondes acoustiques de surface à une seule paire de bornes (211, 212) disposés sur le substrat piézoélectrique selon un motif en échelle, chaque résonateur comprenant une électrode IDT ayant une paire d'électrodes en peigne,
dans lequel
la pluralité de résonateurs à ondes acoustiques de surface à une seule paire de bornes comprend des résonateurs parallèle (212a-c), et tous les résonateurs paralléle (212a-c) sont éclaircis,
la pluralité de résonateurs à ondes acoustiques de surface à une seule paire de bornés (211, 212) sont agencés en une forme de π, avec un résonateur parallèle (211a, c) connecté à chacun des côtés entrée/sortie (213a, b), et
l'électrode IDT d'au moins l'un (212b) des résonateurs parallèle autre que les résonateurs parallèle connectés aux côtés entrée/sortie ont un plus grand rapport d'éclaircissement et un plus petit pas d'électrode que ceux des électrodes IDT des autres résonateurs parallèle (212a, c).

3. Filtre à ondes acoustiques de surface selon la revendication 1, dans lequel le filtre sert de filtre d'émission qui nécessite une atténuation en dehors d'une bande passante au voisinage d'un côté hautes fréquences de la bande passante.

4. Filtre à ondes acoustiques de surface selon la revendication 2, dans lequel le filtre sert de filtre de réception qui nécessite une atténuation en dehors d'une bande passante au voisinage d'un côté basses fréquences de la bande passante.

5. Filtre de branchement comprenant le filtre à ondes acoustiques de surface selon l'une quelconque des revendications précédentes.

6. Appareil de communication comprenant le filtre à ondes acoustiques de surface selon l'une quelconque des revendications précédentes.
